# EUROPEAN PATENT APPLICATION

(11) **EP 2 706 663 A2**
(43) Date of publication of application: **12.03.2014**
(21) Application number: 13183647.0
(22) Date of filing: 10.09.2013
(51) Int. Cl.: H03G 3/34

(54) **Automatic microphone muting of undesired noises**

(30) Priority: 10.09.2012 US 201261698993 P; 17.04.2013 US 201313865008
(71) Applicant: Polycom, Inc., San Jose, CA 95002 (US)
(72) Inventor: Liu, Yibo, Reading, MA Massachusetts 01867 (US); Chu, Peter L., Lexington, MA Massachusetts 02420 (US); Rodman, Jeff, San Francisco, CA California 94116 (US)
(74) Representative: Käck, Stefan

(57) **Abstract**

Methods and systems for cancelation of table noise in a speaker system used for video or audio conferencing are disclosed. Table noise is cancelled in one embodiment by providing a signal or a message whenever a key is depressed on a keyboard or a mouse is clicked. When the key depression signal or message is received, the system (200) evaluates whether speech is occurring. If speech is not occurring, then the microphone (202) in the system (200) is muted. However, if speech is occurring, the microphone (202) is not muted for a period of time to allow the speech to be transmitted to the far end. This allows the conference to be continued in the presence of keyboard sounds if speech is occurring at the same time but also silences the keyboard sounds if speech is not occurring.

## Description

### FIELD OF THE INVENTION

The invention relates to speakerphones and other desk or table-located microphone systems.

### BACKGROUND OF THE INVENTION

There are often undesirable noises occurring continuously during an audio or video conference. Examples of these noises include keyboard sounds and paper rustling. These noises can be distracting, particularly during audio or video conferences with a large group of people when one person's keyboard can disrupt another person's speech. Thus, it is highly desirable to automatically mute the microphone when these sounds are present and no one is talking. However, there is no reliable method to discriminate between speech sounds and noises.

One example of a prior method of dealing with this issue is disclosed in U.S. Patent Application Pub. No. 2008/0279366 which addressed this problem by providing a signal from the user's keyboard to the conferencing application such that the user's computer provides a signal when a key is depressed on the keyboard. The conferencing application, either executing on the computer or on a separate device, mutes the microphone for a period of time upon receiving the key depression signal. While this method is helpful in eliminating keyboard noises, it is problematic because while the keyboard sound is muted, so is any speech occurring at the same time. This can cause gaps in speech and result in confusion and disruption of the conference.

### SUMMARY OF THE INVENTION

The invention is defined in claims 1 and 10, respectively. Particular embodiments are set out in the dependent claims.

In one embodiment according to the present invention, a signal is provided by the computer whenever a key is depressed. The signal is a message to the conferencing application executing on the computer. The signal may be either a high frequency audible tone, a radio frequency signal, such as WiFi or Bluetooth, or a wired signal, such as an Ethernet packet. The conferencing application is performing speech detection on signals received from the conferencing microphone. When the conferencing application receives the key depression signal or message, it evaluates whether speech is occurring. If speech is not occurring, then the microphone is muted. However, if speech is occurring, the microphone is not muted for a period of time to allow the speech to be transmitted to the far end. This allows the conference to be continued in the presence of keyboard sounds if speech is occurring at the same time but also silences the keyboard sounds if speech is not occurring.

### BRIEF DESCRIPTION OF THE FIGURES

The accompanying drawings, which are incorporated in and constitute a part of this specification, illustrate an implementation of apparatus and methods consistent with the present invention and, together with the detailed description, serve to explain advantages and principles consistent with the invention.

Figure 1 is a block diagram of a computer according to one embodiment of the present invention.

Figure 2 is a block diagram of a conferencing device according to one embodiment of the present invention.

Figure 3 is a block diagram of a speech detector according to one embodiment of the present invention.

### DETAILED DESCRIPTION OF THE PREFERRED EMBODIMENTS

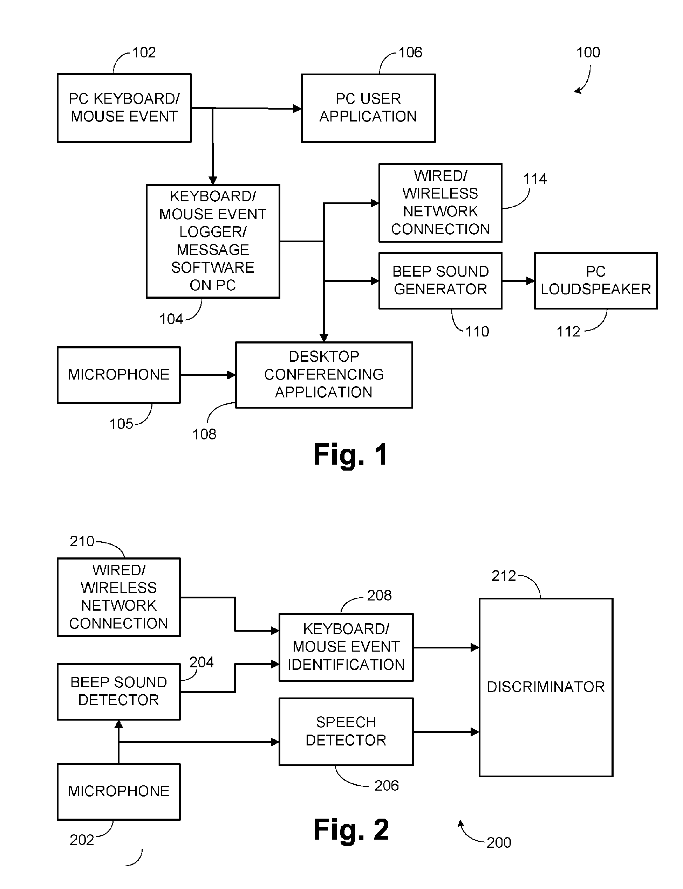

Fig. 1 illustrates portions of a computer 100 which implements one embodiment of the present invention. The computer 100 monitors depressions of the keyboard keys and/or mouse buttons, referred to here as events, shown in block 102. The computer 100 monitors these depressions either through a logging software running in the background or by receiving messages from the keyboard or mouse handlers as shown in block 104. The keyboard or mouse events 102 are provided to both a user application 106, such as a web browser or a word processing program as part of the normal operations of the computer 100. The logging or messaging software of block 104 provides a signal of these events to one of three locations, depending on the conferencing system location and its capabilities. If the conferencing system is a desktop conferencing application, the block 104 sends a message to a conferencing application 108, which could be either video or audio, running on the same computer 100. A microphone 105 is coupled to the conferencing application 108 to allow receipt of speech.

If the conferencing device is a group conferencing system, again either video or audio, in the same room as the computer 100, the keyboard/mouse event triggers the generation of a short beep (e.g., a 20 kHz beep) in block 110, which is provided over the computer loudspeakers in block 112. The short beep is generally inaudible, and is not disturbing to people in the room. While a short beep is preferred, an ultrasonic signal or any signal within the normal audio spectrum but above the normal speech range and having a specific pattern could be used. In an alternative embodiment, the keyboard/mouse event triggers a muting of the microphone.

As a third alternative, the event notification signal can be provided to a network connection, either wired or wireless, in block 114. The wireless network can be WiFi or Bluetooth or other acceptable wireless network. The wired network is preferably Ethernet, but can be over any of the various mediums, such as shielded, twisted pair, powerline, phone line and the like. An event notification network communication is sent to the conferencing device. This embodiment may be necessary if the computer and the conferencing device are physically separate and either in different rooms or if the computer does not have a speaker, but the embodiment can also be used if the computer and the conferencing device are in the same room or the computer has a speaker. The network address of the conferencing device can be done in various ways, such as user input or other methods well known to those skilled in the art.

Fig. 2 illustrates a group conferencing system 200 over a network connection. A microphone 202 on the group conferencing system 200 receives the sounds in the room. The microphone 202 signal is provided to a beep detector 204 and a speech detector 206, as well as the normal conferencing input (not shown). The beep detector 204 is monitoring for the short beep from the computer loudspeaker. If a beep is detected, a signal is provided to a keyboard/mouse event identification block 208. A wired/wireless network connection 210 is provided to receive the event notification network communications signal from the computer. If a communications signal is received, a signal is provided to the identification block 208.

The identification block 208 provides a signal to a discriminator block 212 when a key or button event is received. Although keyboard and mouse noise clicks can be distracting during video or audio conferences, it is preferable to hear these noises if they are being generated simultaneously as a speech by the same participant, than to remove the speech. Thus, a speech detector 206 is used to continuously monitoring the microphone 202 output for speech. If speech is detected, a signal is provided to the discriminator 212.

The discriminator 212 is monitoring for both the key or button event signal from the identification block 208 and the speech signal from the speech detector 206. If a mouse/keyboard event is indicated but there is no speech signal, then the microphone is muted so that the mouse or keyboard noise is not transmitted to the far end. If speech is detected simultaneously during the mouse/keyboard event, the microphone is not muted for a period of time, 1/2 a second for example, since it is desired that all speech should be heard during the conference. Thus, keyboard or mouse clicks are muted except when a speaker is speaking. This allows removal of noise from keyboard or mouse clicks except when speech is occurring, when the provision of the speech, even with the noise, is preferable to allow the conference to proceed smoothly.

In one embodiment, the desktop conferencing application 108 also includes modules similar to the speech detector 206 and the discriminator 212 to allow for detection of speech while keyboard or mouse noise is present and thus avoid removal of speech.

In an alternative embodiment, instead of using the beep generator 110 or the wired/wireless network connection 114, the computer keyboard could directly emit the short beep or transmit the wired or wireless network communication. For example, Bluetooth or RF wireless keyboards and mice are common and could connect to both the computer and to the conferencing device, providing the keyboard or mouse operation to the computer in a normal fashion and a key or button depression communication to the conferencing device directly.

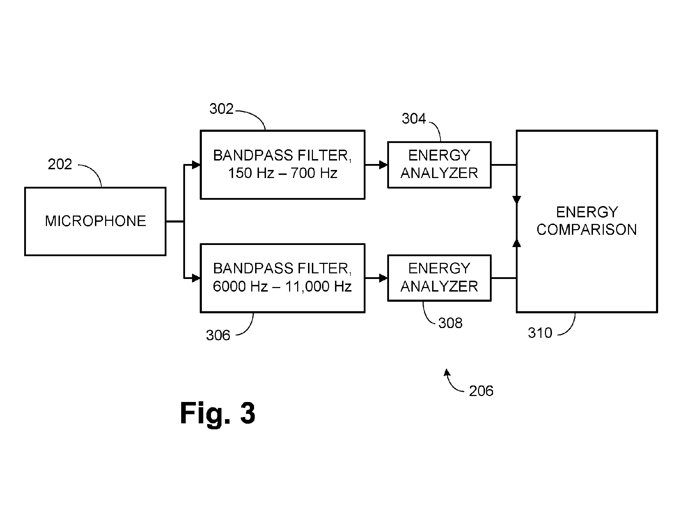

The speech detector 206 may be implemented as shown in Fig. 3, by comparing the low frequency energy with the high frequency energy. A low pass filter 302, preferably between 150 and 700 Hz monitors the signal received by the microphone 202. A low noise energy analyzer block 304 analyzes the output from the low pass filter 302. A high pass filter 306, preferably between 6,000 and 11,000 Hz, also monitors the signal received from the microphone. A high noise energy analyzer block 308 analyzes the high pass filter 306 output. An energy comparison block 310 then receives the outputs of the low and high noise analyzers 304 and 308. If the low frequency energy is greater than the high frequency energy, the block 310 declares speech is present and provides a speech signal.

Thus, while removing disrupting keyboard and mouse noises, the system also determines when speech is present and prevents removal of speech because of keyboard or mouse noise in the presence of speech from the same participant.

It should be emphasized that the previously described embodiments of the present invention, particularly any preferred embodiments, are merely possible examples of implementations, set forth for a clear understanding of the principles of the invention. Many variations and modifications may be made to the previously described embodiments of the invention without departing substantially from the principles of the invention. All such modifications and variations are intended to be included herein within the scope of this disclosure and the present invention and protected by the following claims.

## Claims

1. A system comprising:
a computer (100) providing a signal when a click event (102) occurs; and
a conferencing device (200) which includes a microphone (202) and a speech detector (206) and is coupled to the computer (100) to receive the click event signal, wherein the conferencing device (200) mutes the microphone (105) if a click event signal is received and speech is not detected but does not mute the microphone (202) if a click event signal is received and speech is detected.

2. The system of claim 1, wherein the conferencing device (200) is an application executing on the computer (100) and the signal is a message inside the computer (100).

3. The system of claim 1 or 2, wherein the computer (100) includes a loudspeaker (112) and the click event signal is a high frequency beep audio signal provided from the loudspeaker (112).

4. The system of claim 3, wherein the conferencing device (200) includes a beep detector (204) for detecting the high frequency beep audio signal.

5. The system of any of the preceding claims, wherein the computer (100) includes a network interface (114) and the click event signal is provided over the network interface (114), and wherein the conferencing device (200) includes a network interface (210) for receiving the click event signal.

6. The system of any of the preceding claims, wherein the conferencing device (200) includes a speech detector (206) for detecting when speech is occurring.

7. The system of any of the preceding claims, wherein the conferencing device (200) further includes a discriminator (212) for monitoring for the click event and for speech and determining if the click event and the speech occur at the same time.

8. The system of any of the preceding claims, wherein the microphone (105) is not muted for a predetermined period of time if the click event signal is received and speech is detected at the same time.

9. The system of any of the preceding claims, further comprising a keyboard wherein the keyboard provides the click event signal.

10. A noise cancellation method comprising:
receiving a signal when a click event occurs;
receiving sounds by a microphone (202);
detecting when speech occurs; and
muting the microphone (202) if the click event signal is received and speech is not detected and not muting the microphone (202) if the click event signal is received and speech is detected at the same time.

11. The method of claim 10, wherein the click event signal is a high frequency beep audio signal provided from a loudspeaker (112).

12. The method of claim 11, further comprising detecting the high frequency beep audio signal by using a beep detector (204).

13. The method of any of claims 10-12, further comprising receiving the click event signal over a network interface (210).

14. The method of any of claims 10-13, further comprising monitoring for the click event and for speech and determining if the click event and the speech occur at the same time.

15. The method of any of claims 10-14, wherein the microphone (202) is not muted for a predetermined period of time if the click event signal is received and speech is detected at the same time.
